# FASCICULE DE BREVET EUROPEEN

(11) **EP 1 045 254 B1**
(45) Date de publication et mention de la délivrance du brevet: **12.01.2005**
(21) Numéro de dépôt: 00401008.8
(22) Date de dépôt: 12.04.2000
(51) Int. Cl.: G01R 31/327, G01R 31/02

(54) **Procédé de controle de la fin de course d'un organe mobile et dispositif pour sa mise en oeuvre**
Verfahren zur Überwachung der Endstellung eines mobilen Elements und Vorrichtung zur Durchführung des Verfahrens
Method for monitoring the end of travel of a mobile element and device for carrying out the method

(30) Priorité: 16.04.1999 FR 9904792
(43) Date de publication de la demande: 18.10.2000
(73) Titulaire: Delphi Technologies, Inc., Troy, MI 48007 (US)
(72) Inventeur: Krier, Antoine, 91250 St. Germain/Corbeil (FR)
(74) Mandataire: Abello, Michel

(56) Documents cités:
- US-A- 3 928 795
- US-A- 4 862 091
- US-A- 5 109 199
- US-A- 5 436 789
- PATENT ABSTRACTS OF JAPAN vol. 1998, no. 01, 30 janvier 1998 (1998-01-30) & JP 09 249360 A (TOSHIBA ELEVATOR TECHNOS KK), 22 septembre 1997 (1997-09-22)
- PATENT ABSTRACTS OF JAPAN vol. 017, no. 147 (P-1508), 24 mars 1993 (1993-03-24) & JP 04 317197 A (FUJITSU LTD), 9 novembre 1992 (1992-11-09)

## Description

La présente invention concerne un procédé de contrôle d'au moins une position de fin de course d'au moins un organe mobile apte à être entraîné par un actionneur électrique, et un dispositif pour la mise en oeuvre de ce procédé.

Lorsqu'un organe mobile est déplacé automatiquement par un actionneur électrique, il est nécessaire de prévoir des contacteurs de fin de course, pour signaler la position de fin de course de l'organe mobile et interrompre l'alimentation électrique de l'actionneur. Toutefois, ces contacteurs peuvent subir des pannes, de sorte que l'orsque l'organe mobile arrive en fin de course, l'information correspondante n'est pas fournie à l'actionneur électrique qui continue à entraîner l'organe mobile, ce qui peut engendrer des dégâts, lorsque la masse de l'organe est importante. Par exemple, dans certains véhicules automobiles à toit escamotable, le toit vient s'escamoter dans un compartiment situé au niveau du coffre arrière, en position ouverte du hayon de coffre. Dans ce cas, si la position de fin de course de déplacement du hayon ou du toit n'est pas signalée aux moteurs électriques, ces deux organes en déplacement synchronisé peuvent se heurter, ou bien poursuivre leur mouvement, engendrant des dommages au niveau de leurs articulations respectives ou des autres parties du véhicule.

Les circuits de détection associés aux contacteurs peuvent subir différents types de panne, les plus fréquentes consistant en l'arrachement d'un fil, ce qui se traduit par une ouverture du circuit, en un contact électrique accidentel entre la masse et un fil, ce qui se traduit par un court-circuit à la masse, et en un contact accidentel entre un fil du circuit de détection et un fil d'alimentation électrique, ce qui se traduit par un court-circuit à un potentiel donné.

Le document US-A-4 862 091 décrit un arrangement de circuit pour surveiller les lignes de connexion d'un dispositif commutable ouvert à l'état normal, cet arrangement comprenant : une première résistance en série avec ledit dispositif ; une seconde résistance en parallèle avec la première résistance et le dispositif pour former un circuit parallèle ; une première ligne de connexion reliant ledit circuit parallèle au potentiel de la terre ; une seconde ligne de connexion reliant ledit circuit parallèle à une source de tension au moyen d'une troisième résistance et à un discriminateur de tension ; une diode Zener montée en série avec la seconde résistance et capable de déconnecter la seconde résistance ; et la dite source de tension comporte une première tension de sortie plus grande que la tension d'amorçage de la diode Zener et une seconde tension de sortie plus faible que la tension d'amorçage de la diode Zener, et des moyens pour sélectionner la première ou la deuxième tension de sortie.

Le document US-A-5 436 789 décrit un équipement de surveillance de changement de signal utilisable en particulier dans des systèmes de commande à auto-vérification.

Un but de l'invention est donc de contrôler l'état de fonctionnement d'un contacteur de fin de course, avant de commander le déplacement de l'organe mobile qui est destiné à venir en butée de fin de course contre ledit contacteur. A cet effet, il est nécessaire de vérifier que le circuit de détection du contacteur ne soit pas en circuit ouvert accidentel ou en court-circuit à un potentiel inattendu

Une solution pourrait consister, d'une part, à maintenir le contacteur fermé, tant que l'organe mobile n'est pas en butée de fin de course contre ce dernier, et à ouvrir ledit contacteur, lorsque l'organe mobile est en butée de fin de course contre ce dernier, et d'autre part, à engendrer dans le circuit de détection une tension variable et à détecter la tension résultante en sortie du circuit de détection. Ainsi, lorsque le contacteur est fermé et fonctionne correctement, les variations de la tension résultante détectée doivent être sensiblement identiques aux variations de la tension engendrée, alors que si le circuit de détection est accidentellement ouvert ou en court-circuit à un potentiel inattendu, la tension résultante présente une amplitude constante.

Il est important que le contacteur soit fermé, en l'absence de mise en butée de l'organe mobile, car dans le cas contraire, il ne serait pas possible de distinguer entre la position ouverte du contacteur et une ouverture accidentelle du circuit de détection.

Toutefois, ce contrôle préalable de l'état du contacteur, avant le déplacement de l'organe mobile, ne permet pas de s'assurer qu'aucune panne n'interviendra au cours du déplacement de l'organe mobile jusqu'à sa position de fin de course. Ce risque est d'autant plus important que la durée de la course de l'organe est grande. En effet, si le circuit de détection s'ouvre accidentellement pendant le déplacement de l'organe, il ne sera plus possible de détecter la position de fin de course de l'organe, car cette position correspond également à une ouverture du circuit par le contacteur.

L'invention a donc pour but de proposer un procédé de contrôle de l'état de fonctionnement d'un contacteur de fin de course, aussi bien en statique avant le déplacement de l'organe mobile, qu'en dynamique, pendant le déplacement de l'organe mobile jusqu'à sa position de fin de course.

A cet effet, l'invention a pour objet un procédé de contrôle d'au moins une position de fin de course d'au moins un or ane mobile apte à être entraîné par un actionneur électrique, le procédé présentant les caractéristiques définies dans la revendication 1.

D'autres caractéristiques du procédé apparaissent dans les revendications dépendantes 1 à 5.

L'invention vise également un dispositif pour la mise en oeuvre du procédé défini dans la revendication 1, ledit dispositif présentant les caractéristiques définies dans la revendication 6.

D'autres caractéristiques du dispositif apparaissent dans les revendications dépendantes 7 à 10.

Pour mieux faire comprendre l'objet de l'invention, on va en décrire maintenant, à titre d'exemples purement illustratifs et non limitatifs, plusieurs modes de réalisation représentés sur le dessin annexé.

Sur ce dessin :
- la figure 1 est un schéma électrique simplifié d'un premier mode de réalisation du dispositif de l'invention, lorsque le contacteur est à l'état fermé ;
- la figure 2 est une vue analogue à la figure 1, mais représente le contacteur à l'état ouvert ;
- la figure 3 est une vue schématique partielle d'un véhicule automobile à toit escamotable, équipé du dispositif de l'invention ; et
- la figure 4 est un schéma électrique simplifié d'un deuxième mode de réalisation du dispositif de l'invention.

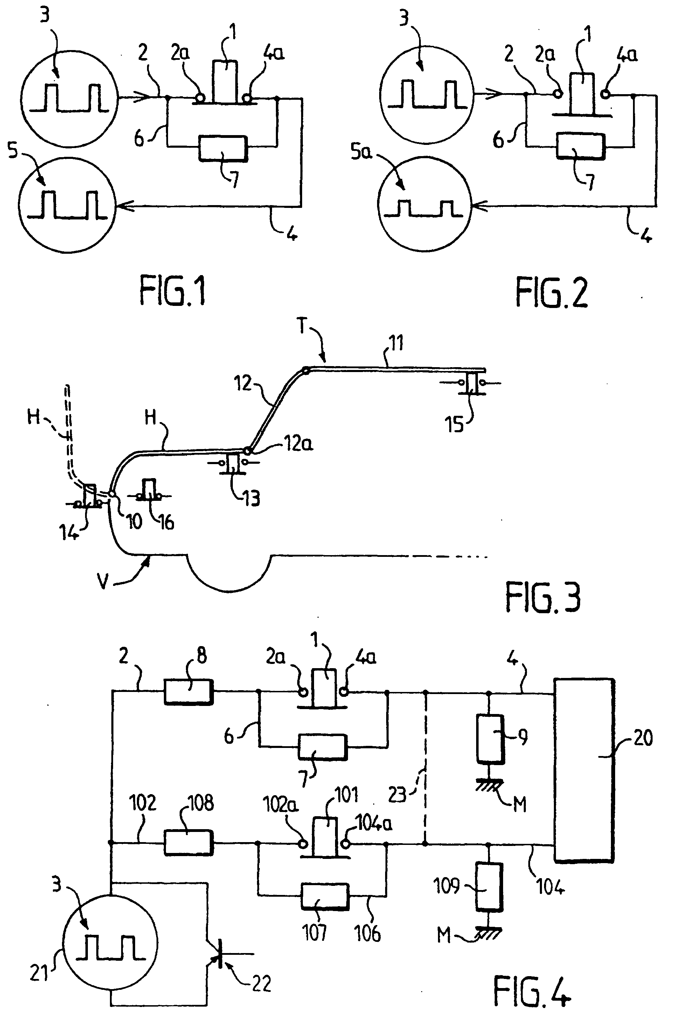

Sur la figure 1, on a représenté une partie du circuit de détection associé à un contacteur de butée 1. Le circuit de détection comporte une ligne d'entrée 2 à laquelle est appliqué un signal à tension hachée 3 et une ligne de sortie 4 pour délivrer le signal résultant 5. Au repos, le contacteur 1 est sollicité contre deux bornes 2a, 4a des lignes 2, 4 respectivement, pour assurer la fermeture du circuit. Un pont diviseur 6 comportant une résistance 7 est monté en parallèle au contacteur 1, une borne du pont 6 étant connectée à la ligne 2 en amont de la borne 2a, et l'autre borne du pont 6 étant connectée à la ligne 4, en aval de la borne 4a.

Comme visible sur la figure 2, lorsque le contacteur 1 est en service, c'est-à-dire lorsqu'un organe vient en butée contre le contacteur 1, celui-ci s'écarte des bornes 2a, 4a, ce qui provoque l'ouverture du circuit entre lesdites bornes. Dès lors, le courant électrique passe par le pont diviseur 6, ce qui donne en sortie un signal haché à amplitude réduite 5a.

Bien que cela ne soit pas représenté sur les figures 1 et 2, les signaux 3, 5 et 5a sont reçus par une unité de traitement électronique qui comporte un microcontrôleur équipé d'un convertisseur analogique/numérique, pour analyser et comparer les signaux de sortie 5, 5a avec le signal d'entrée 3.

A titre d'exemple, le signal à tension variable peut comporter des créneaux ayant une amplitude d'environ 12 V, ce qui correspond à la tension d'alimentation de la batterie d'un véhicule automobile, avec une période d'interruption de l'ordre de 10 ms. Le contrôle du contacteur 1 s'effectue juste avant de démarrer l'actionneur électrique qui entraîne l'organe mobile et pendant toute la durée du déplacement de l'organe mobile qui peut être de l'ordre de 15 à 20 s. La valeur de la résistance 7 du pont diviseur 6 peut être de l'ordre de 10 kΩ. Le lancement du contrôle du contacteur peut être déclenché par une commande d'actionnement du moteur électrique.

Grâce à l'invention, on a réalisé un circuit de détection à liaison électrique permanente, lors du fonctionnement normal du contacteur, que celui-ci soit à l'état fermé ou ouvert, le changement d'état du contacteur étant détecté par une variation de l'amplitude du signal délivré par le circuit de détection.

Ainsi, lorsqu'il se produit une panne résultant d'une ouverture ou d'un court-circuit accidentel du circuit de détection, le signal de sortie présente une amplitude constante à un potentiel donné, généralement 0V ou 12V, ce qui permettra à l'unité de traitement de distinguer une panne de l'état ouvert ou fermé du contacteur. Lorsqu'une panne est détectée avant le déplacement de l'organe mobile, l'alimentation de l'actionneur est empêchée, alors que si elle se produit au cours du déplacement de l'organe, l'actionneur est arrêté.

Sur la figure 3, on a représenté schématiquement une partie d'un véhicule V comportant un hayon de coffre H articulé à son bord arrière 10 sur le châssis du véhicule, et un toit escamotable T en deux parties articulées 11, 12, la partie 11 correspondant à la paroi supérieure de l'habitacle et la partie 12, à la lunette arrière du véhicule, la partie 12 étant montée pivotante à son bord arrière 12a sur le châssis du véhicule.

Le hayon H est apte à être déplacé par un actionneur électrique (non représenté) entre une position fermée (représentée en trait plein sur la figure 3) dans laquelle il vient en butée avec un contacteur de fin de course 13, et une position ouverte basculée vers l'arrière (représentée en traits interrompus sur la figure 3) dans laquelle il coopère avec un deuxième contacteur de fin de course 14. De manière analogue, le toit escamotable T est apte à être déplacé par un autre actionneur électrique (non représenté) entre une position fermée (représentée en trait plein sur la figure 3) dans laquelle la partie supérieure 11 est en butée contre un contacteur de fin de course 15, et une position ouverte (non représentée) dans laquelle la partie 12 est en butée contre un deuxième contacteur de fin de course 16 situé dans le coffre du véhicule.

Compte tenu de la masse importante du toit escamotable T et du hayon H, et de la synchronisation des déplacements de ces deux organes, il est nécessaire de s'assurer que les contacteurs 13 à 16 fonctionnent bien avant et pendant le déplacement de ces organes. En effet, l'arrêt de chaque actionneur électrique est provoqué par la mise en butée de l'organe mobile contre son contacteur de fin de course.

Sur la figure 4, on a représenté un schéma électrique plus détaillé pour le contrôle d'un circuit de détection à deux contacteurs. Bien entendu, ce principe peut être généralisé à un nombre quelconque de contacteurs.

Sur la figure 4, le circuit de détection comporte deux lignes d'entrée en parallèle 2, 102, sur chacune d'entre elles est montée en série une résistance 8, 108. La borne 2a, 102a de chaque ligne 2, 102, est apte à être reliée à la borne 4a, 104a d'une ligne de sortie respective 4, 104, par l'intermédiaire d'un contacteur 1, 101. Chaque ligne de sortie 4, 104 est reliée en parallèle à la masse M (par exemple, la carrosserie du véhicule) par l'intermédiaire d'une résistance de polarisation respective 9, 109. Toutes les lignes de sortie 4, 104 sont reliées à une même unité de traitement 20, qui est généralement constituée d'un micro contrôleur muni d'un convertisseur analogique/numérique. Un pont diviseur 6, 106 muni d'une résistance 7, 107 est monté en parallèle à chaque contacteur 1, 101 pour établir une dérivation entre la ligne d'entrée 2, 102 et la ligne de sortie 4, 104, lorsque le contacteur associé est à l'état ouvert.

Toutes les lignes d'entrée 2, 102 sont connectées à un seul générateur de courant continu 21, qui est commandé par un transistor 22 pour délivrer un signal à tension variable. La génération d'un tel signal étant connue en soi, elle ne sera pas décrite plus en détail.

L'unité 20 est destinée à recevoir le signal engendré 3 et les signaux de sortie provenant des lignes 4, 104, pour les comparer après conversion numérique.

Dans le cas relativement rare où un court-circuit se produirait entre deux lignes du circuit de détection, par exemple les lignes 4, 104, comme matérialisé par le trait interrompu 23, l'unité 20 continue à recevoir un signal à tension variable, contrairement aux autres types de panne. Il est donc nécessaire de pouvoir distinguer l'amplitude du signal de sortie selon la présence ou non d'un court-circuit entre les lignes des différents contacteurs. Le fait d'ajouter les résistances 8, 108, permet d'effectuer une telle distinction. Si on utilise un convertisseur analogique/numérique à 8 bits, il est possible de distinguer l'amplitude d'un signal avec une précision de l'ordre du 1/256.

En l'absence des résistances 8, 108, l'unité 20 ne serait pas capable de distinguer le changement d'état des contacteurs, dans certains cas particuliers, comme expliqué ci-dessous. Prenons pour hypothèse de départ que toutes les résistances 7, 107 et 9, 109 sont identiques.

En l'absence du court-circuit 23, si le contacteur 1 est ouvert, le signal de sortie aura une amplitude réduite de moitié. Si le contacteur 1 est fermé, le signal de sortie aura la même amplitude que le signal d'entrée.

En présence du court-circuit 23, si le contacteur 101 reste ouvert, l'amplitude du signal de sortie provenant du contacteur 1 sera réduite de moitié lorsque le contacteur 1 sera également ouvert et sera identique à celle du signal d'entrée lorsque le contacteur 1 sera fermé. On constate que, dans ce cas, l'information reçue par l'unité 20 reste inchangée, en présence du court-circuit 23. Autrement dit, le fonctionnement du dispositif n'est pas affecté par la présence d'un tel court-circuit.

En revanche, en présence du court-circuit 23, si le contacteur 101 reste fermé, l'amplitude du signal de sortie provenant du contacteur 1 restera identique à celle du signal d'entrée, lorsque le contacteur 1 sera aussi bien à l'état ouvert que fermé. Autrement dit, l'unité 20 ne sera pas capable de percevoir le changement d'état du contacteur 1.

Comme expliqué ci-dessous, l'utilisation des résistances 8, 108 permet d'éviter ce défaut.

A titre d'exemple, les résistances 8, 108 peuvent avoir la même valeur que les autres résistances du circuit.

Dans ce cas, en l'absence du court-circuit 23, l'amplitude du signal de sortie est réduite à 1/3 lorsque le contacteur 1 est ouvert, et réduite à 1/2 lorsque le contacteur 1 est fermé.

En présence du court-circuit 23, si le contacteur 101 reste ouvert, l'amplitude du signal de sortie provenant du contacteur 1 sera réduite à 1/3 lorsque le contacteur 1 sera ouvert, et sera réduite à 3/7 lorsque le contacteur 1 sera fermé. Ceci signifie que lorsque le contacteur 101 est ouvert, l'unité 20 reçoit l'information correcte sur l'état ouvert du contacteur 1, de sorte que le dispositif fonctionne correctement dans ce cas de figure. D'autre part, lorsque le contacteur 101 est ouvert et le contacteur 1 est fermé, l'unité 20 est informée de la panne car l'amplitude du signal de sortie (3/7) est différente des deux valeurs possibles (1/2 ou 1/3) pour l'amplitude, en fonctionnement normal.

De manière analogue, en présence du court-circuit 23, si le contacteur 101 reste fermé, l'amplitude du signal de sortie provenant du contacteur 1 sera réduite à un 1/2 si le contacteur 1 est fermé et à 3/7 si le contacteur 1 est ouvert. Autrement dit, si les deux contacteurs 1 et 101 sont fermés, l'unité 20 recevra l'information correcte concernant l'état fermé du contacteur 1. D'autre part, si le contacteur 1 est ouvert et le contacteur 101 est fermé, l'unité 20 sera capable de distinguer la différence d'amplitude de 3/7 par rapport aux deux valeurs possibles pour l'amplitude, lors du fonctionnement normal.

Ainsi, grâce aux résistances 8, 108, en cas de court-circuit 23, le dispositif pourra soit fonctionner normalement, soit signaler une panne. En aucun cas, l'unité 20 pourra être trompée sur l'état des contacteurs.

D'une manière plus générale, l'émission du signal de contrôle pourra être déclenchée par un signal de commande de la mise en marche de l'actionneur électrique destiné à entraîner l'organe mobile. La mise en route effective de l'actionneur électrique n'interviendra qu'après un contrôle préalable de l'état de tous les contacteurs par le dispositif de l'invention. Ce contrôle de l'état des contacteurs se poursuivra pendant tout le déplacement de l'organe mobile. Dans le cas où une panne est détectée par le dispositif, le dispositif pourra déclencher l'arrêt de tous les actionneurs électriques ou de certains d'entre eux et/ou signaler à l'utilisateur la panne, par exemple sous la forme d'un signal lumineux ou sonore.

Bien que l'invention ait été décrite en liaison avec plusieurs variantes de réalisation particulières, il est bien évident qu'elle n'y est nullement limitée et qu'elle comprend tous les équivalents techniques des moyens décrits ainsi que leurs combinaisons, si celles-ci entrent dans le cadre de l'invention telle que définie dans les revendications suivantes.

## Revendications

1. Procédé de contrôle d'au moins une position de fin de course d'au moins un organe mobile (T, H) apte à être entraîné par un actionneur électrique, consistant à détecter chaque position de fin de course au moyen d'un circuit de détection (2, 4, 102, 104) comprenant au moins un contacteur de butée (1, 13-16, 101) apte à s'ouvrir ou se fermer lorsqu'il coopère avec l'organe mobile, ledit circuit de détection ayant une liaison permanente (6, 106) dont la valeur de la résistance change selon l'état fermé ou ouvert du contacteur, à fermer ou ouvrir le contacteur, lorsque l'organe mobile n'est pas en butée de fin de course contre ledit contacteur, à ouvrir ou fermer le contacteur, lorsque l'organe mobile est en butée de fin de course contre ledit contacteur, à engendrer dans le circuit de détection un signal de contrôle, à recevoir le signal (5, 5a) provenant du circuit de détection dans une unité de traitement du signal (20), à signaler une panne du contacteur lorsque l'amplitude du signal reçu est sensiblement constante, et à signaler les états ouvert et fermé en fonction de la valeur du signal de contrôle reçu par l'unité de traitement, **caractérisé par le fait qu'**il consiste à engendrer, à titre de signal de contrôle, un signal (3) à amplitude variable, que ledit signal de contrôle à amplitude variable est engendré avant et pendant le déplacement de l'organe mobile vers le contacteur, et que l'état fermé du contacteur est signalé lorsque la différence d'amplitude entre le signal engendré (3) et le signal reçu (5) est sensiblement égale à une première valeur prédéterminée, et l'état ouvert du contacteur est signalé lorsque ladite différence d'amplitude est sensiblement égale à une deuxième valeur prédéterminée supérieure à ladite première valeur, et **par le fait qu'**il consiste à mettre plusieurs contacteurs (1, 101) en parallèle sur le circuit de détection et à engendrer le même signal de contrôle (3) pour tous les contacteurs, et à signaler un court-circuit (23) entre au moins deux contacteurs (1, 101) du circuit de détection, lorsque la différence d' amplitude précitée est différente des première et deuxième valeurs précitées.

2. Procédé selon la revendication 1, **caractérisé par le fait qu'**il consiste à mettre un pont diviseur (6, 106) en parallèle sur chaque contacteur (1, 101) du circuit de détection pour établir ladite liaison permanente, ladite deuxième valeur étant déterminée par la valeur de la résistance (7, 107) du pont diviseur.

3. Procédé selon la revendication 1 ou 2, **caractérisé par le fait qu'**il consiste à signaler un court-circuit à la masse (M) ou une ouverture accidentelle du circuit de détection, lorsque l'amplitude du signal reçu est sensiblement nulle, et à signaler un court-circuit avec un fil d'alimentation lorsque l'amplitude du signal reçu est sensiblement constante et égale à la tension d'alimentation.

4. Procédé selon la revendication 1, **caractérisé par le fait qu'**il consiste à mettre au moins une résistance (8, 108) en série avec chaque contacteur (1, 101) sur le circuit de détection, et à signaler un court-circuit (23) entre deux contacteurs du circuit de détection, lorsque la différence d'amplitude précitée est différente des première et deuxième valeurs précitées. ,

5. Procédé selon l'une des revendications 1 à 4, **caractérisé par le fait qu'**il consiste à engendrer un signal haché périodique (3) dont l'amplitude des créneaux est constante, par exemple de l'ordre de 12 V.

6. Dispositif pour la mise en oeuvre du procédé selon l'une des revendications 1 à 5, comportant au moins un actionneur électrique apte à entraîner le déplacement d'au moins un organe mobile (H, T), un circuit de détection (2, 4, 102, 104) comprenant au moins un contacteur de butée (1, 101, 13-16) apte à s'ouvrir ou se fermer lorsque l'organe mobile est en butée de fin de course contre ledit contacteur, et à se fermer ou s'ouvrir lorsque l'organe mobile n'est pas en butée de fin de course contre ledit contacteur, ledit circuit de détection établissant une liaison permanente (6, 106) dont la valeur de la résistance (7, 107) change selon l'état fermé ou ouvert du contacteur, un générateur (21) pour engendrer un signal de contrôle dans le circuit de détection, une unité de traitement du signal (20) destinée à recevoir le signal (5, 5a) en sortie du circuit de détection, à signaler une panne du contacteur lorsque l'amplitude du signal reçu est sensiblement constante, et à signaler les états ouvert et fermé en fonction de la valeur du signal de contrôle reçu par l'unité de traitement, **caractérisé par le fait que** le générateur (21) est agencé pour engendrer un signal à amplitude variable avant et pendant le déplacement de l'organe mobile vers le contacteur, et que ladite unité de traitement est agencée pour signaler l'état fermé du contacteur, lorsque la différence d'amplitude entre les signaux engendrés et reçus est sensiblement égale à une première valeur prédéterminée, et pour signaler l'état ouvert du contacteur lorsque la différence d'amplitude précitée est sensiblement égale à une deuxième valeur prédéterminée supérieure à ladite première valeur, et **par le fait que** le circuit de détection comporte plusieurs contacteurs (1, 101) en parallèle entre le générateur (21) et l'unité de traitement (20), et que le circuit de détection comporte en série avec chaque contacteur (1, 101) une résistance supplémentaire (8, 108) déterminant au moins une troisième valeur pour la différence d'amplitude précitée, dans le cas d'un court-circuit (23) entre deux contacteurs.

7. Dispositif selon la revendication 6, **caractérisé par le fait que** le circuit de détection comporte un pont diviseur (6, 106) monté en parallèle sur chaque contacteur (1, 101) pour établir une liaison permanente, la valeur de la résistance (7, 107) du pont diviseur déterminant la deuxième valeur précitée.

8. Dispositif selon la revendication 6 ou 7, **caractérisé par le fait que** l'unité de traitement (20) comporte un microcontrôleur et un convertisseur analogique/numérique.

9. Dispositif selon l'une des revendications 6 à 8, **caractérisé par le fait que** le circuit de détection comporte entre chaque contacteur (1, 101) et l'unité de traitement (20), une résistance (9, 109) de polarisation à la masse (M) ou à une borne positive.

10. Dispositif selon la revendication 6, **caractérisé par le fait qu'**il est incorporé dans un véhicule automobile (V) pour contrôler les contacteurs de fin de course (13-16) d'au moins un organe mobile, tel qu'un toit escamotable (T) et/ou un hayon de coffre (H).

## Claims

1. A method for monitoring and testing at least one end-of-travel position of at least one mobile mechanism (T, H) capable of being driven by an electric actuator, consisting in detecting each end-of-travel position by means of a detection circuit (2, 4, 102, 104) comprising at least one limit switch (1, 13-16, 101) capable of opening or closing in cooperation with the mobile mechanism, the said detection circuit having a permanent link (6, 106) whose resistance value changes according to the open or closed state of the limit switch, in closing or opening the limit switch when the mobile mechanism is not at its end-of-travel against the said switch, in opening or closing the switch when the mobile mechanism is at its end-of-travel against the said switch, in generating a test signal in the detection circuit, in receiving the signal (5, 5a) originating in the detection circuit in a signal processing unit (20), in warning of a failure in the limit switch when the received signal has a substantially constant amplitude, and in indicating the open and closed states depending on the value of the test signal received by the processing unit, **characterized in that** it consists in generating, as a test signal, a signal (3) of variable amplitude, **in that** the said variable amplitude test signal is generated prior to and during the displacement of the mobile mechanism towards the limit switch, and **in that** the closed state of the switch is indicated when the amplitude difference between the generated signal (3) and the received signal (5) is substantially equal to a first predetermined value, and the open state of the limit switch is indicated when the said amplitude difference is substantially equal to a second predetermined value greater than the said first value, and **in that** it consists in connecting several switches (1, 101) in parallel on the detection circuit and in generating the same test signal (3) for all the switches, and in warning of a short-circuit (23) between at least two switches (1, 101) of the detection circuit when the aforementioned amplitude difference is different from the first or second aforementioned values.

2. Method according to Claim 1, **characterized in that** it consists in connecting a potential divider (6, 106) in parallel with each switch (1, 101) of the detection circuit in order to establish the said permanent link, the said second value being determined by the resistance value (7, 107) of the potential divider.

3. Method according to either of Claims 1 and 2, **characterized in that** it consists in warning of a short-circuit to ground (M), or of an accidental breaking of the detection circuit, when the amplitude of the received signal is substantially zero, and in warning of a short-circuit to a power supply wire when the amplitude of the received signal is substantially constant and equal to the supply voltage.

4. Method according to Claim 1, **characterized in that** it consists in connecting at least one resistor (8, 108) in series with each switch (1, 101) on the detection circuit, and in warning of a short-circuit (23) between two switches of the detection circuit when the aforementioned amplitude difference is different from the aforementioned first and second values.

5. Method according to one of Claims 1 to 4, **characterized in that** it consists in generating a periodic chopped signal (3) whose pulse heights are of constant amplitude, for example about 12V.

6. Device for implementing the method according to one of Claims 1 to 5, comprising at least one electric actuator capable of driving the displacement of at least one mobile mechanism (H, T), a detection circuit (2, 4, 102, 104) comprising at least one limit switch (1, 101, 13-16) capable of opening or closing when the mobile mechanism is at its end-of-travel against the said switch, and of closing or opening when the mobile mechanism is not at its end-of-travel against the said switch, the said detection circuit establishing a permanent link (6, 106) whose resistance value (7, 107) changes according to the open or closed state of the limit switch, a generator (21) for generating a test signal in the detection circuit, a signal processing unit (20) designed to receive the signal (5, 5a) at the output of the detection circuit, to warn of a failure in the limit switch when the amplitude of the received signal is substantially constant, and to indicate the open and closed states depending on the value of the test signal received by the processing unit, **characterized in that** the generator (21) is designed to generate a signal of variable amplitude prior to and during the displacement of the mobile mechanism towards the limit switch, and **in that** the processing unit is designed to indicate the closed state of the switch when the amplitude difference between the generated and the received signals is substantially equal to a first predetermined value, and to indicate the open state of the limit switch when the said amplitude difference is substantially equal to a second predetermined value greater than the said first value, and **in that** the detection circuit comprises several switches (1, 101) in parallel between the generator (21) and the processing unit (20), and **in that** the detection circuit comprises, in series with each switch (1, 101), an additional resistor (8, 108) determining at least a third value for the aforementioned amplitude difference, in the case of a short-circuit (23) between two switches.

7. Device according to Claim 6, **characterized in that** the detection circuit comprises a potential divider (6, 106) connected in parallel with each switch (1, 101) in order to establish a permanent link, the value of the resistor (7, 107) of the potential divider determining the aforementioned second value.

8. Device according to either of Claims 6 and 7, **characterized in that** the processing unit (20) comprises a microprocessor and an analogue-to-digital converter.

9. Device according to one of Claims 6 to 8, **characterized in that** the detection circuit comprises a resistor (9, 109) biasing to ground (M) or to a positive terminal between each switch (1, 101) and the processing unit (20).

10. Device according to Claim 6, **characterized in that** it is incorporated into an automobile vehicle (V) for monitoring and testing the limit switches (13-16) of at least one mobile mechanism, such as a convertible roof (T) and/or tailgate (H).

## Patentansprüche

1. Verfahren zur Überwachung wenigstens einer Endstellung wenigstens eines mobilen Elementes (T, H), das durch ein elektrisches Betätigungsmittel bewegt werden kann, wobei man jede Endstellung mittels einer Detektionsschaltung (2, 4, 102, 104) detektiert, die wenigstens einen Anschlagschalter (1, 13-16, 101) umfasst, der sich öffnen oder schließen kann, wenn er mit dem mobilen Element zusammenwirkt, wobei die Detektionsschaltung eine permanente Verbindung (6, 106) aufweist, deren Widerstandswert sich in Abhängigkeit vom geschlossenen oder offenen Zustand des Schalters ändert, man den Schalter schließt oder öffnet, wenn das mobile Element sich nicht in der Endstellung im Anschlag gegen den Schalter befindet, man den Schalter öffnet oder schließt, wenn sich das mobile Element in der Endstellung im Anschlag gegen den Schalter befindet, man in der Detektionsschaltung ein Kontrollsignal erzeugt, das von der Detektionsschaltung stammende Signal (5, 5a) in einer Signalverarbeitungseinheit (20) empfängt, man eine Störung des Schalters meldet, wenn die Amplitude des empfangenen Signals im Wesentlichen konstant ist und man die offenen und geschlossenen Zustände abhängig von dem Wert des von der Verarbeitungseinheit empfangenen Kontrollsignals meldet, **dadurch gekennzeichnet, dass** man als Kontrollsignal ein Signal (3) mit variabler Amplitude erzeugt, dass das Kontrollsignal mit variabler Amplitude vor und während der Bewegung des mobilen Elements zum Schalter hin erzeugt wird, und dass der geschlossene Zustand des Schalters dann angezeigt wird, wenn die Amplitudendifferenz zwischen dem erzeugten Signal (3) und dem empfangenen Signal (5) im Wesentlichen einem ersten vorgegebenen Wert entspricht, und der offene Zustand des Schalters angezeigt wird, wenn die Amplitudendifferenz im Wesentlichen einem zweiten vorgegebenen Wert entspricht, der größer als der erste Wert ist, und dadurch, dass man in der Detektionsschaltung mehrere Schalter (1, 101) parallel schaltet und man das gleiche Kontrollsignal (3) für alle Schalter erzeugt und man einen Kurzschluss (23) zwischen wenigstens zwei Schaltern (1, 101) der Detektionsschaltung meldet, wenn die Amplitudendifferenz von dem ersten und dem zweit Wert abweicht.

2. Verfahren gemäß Anspruch 1, **dadurch gekennzeichnet, dass** man zur Bildung der permanenten Verbindung einen Spannungsteiler (6,106) parallel zu jedem Schalter (1, 101) der Detektionsschaltung schaltet, wobei der zweite Wert durch den Wert des Widerstands (7, 107) des Spannungsteilers bestimmt wird.

3. Verfahren gemäß Anspruch 1 oder 2, **dadurch gekennzeichnet, dass** man einen Kurzschluss zur Masse (M) oder eine irrtümliche Öffnung der Detektionsschaltung anzeigt, wenn die Amplitude des empfangenen Signals im Wesentlichen Null ist und man einen Kurzschluss mit der Versorgungsleitung anzeigt, wenn die Amplitude des empfangenen Signals im Wesentlichen konstant ist und der Versorgungsspannung entspricht.

4. Verfahren gemäß Anspruch 1. **dadurch gekennzeichnet, dass** man wenigstens einen Widerstand (8, 108) in Reihe mit jedem Schalter (1, 101) der Detektionsschaltung schaltet und einen Kurzschluss (23) zwischen zwei Schaltern der Detektionsschaltung anzeigt, wenn die Amplitudendifferenz von den ersten und zweiten Werten abweicht.

5. Verfahren gemäß einem der Ansprüche 1 bis 5, **dadurch gekennzeichnet, dass** man ein periodisches zerhacktes Signal (3) erzeugt, dessen Spitzenamptitude konstant ist und beispielsweise in der Größenordnung von 12 V liegt.

6. Vorrichtung zur Durchführung des Verfahrens gemäß einem der Ansprüche 1 bis 5, mit wenigstens einem elektrischen Betätigungsmittel, das die Bewegung wenigstens eines mobilen Elements (H, T) bewirken kann, einer Detektionsschaltung (2, 4, 102, 104} mit wenigstens einem Anschlagschalter (1, 101, 13-16), der sich öffnen oder schließen kann, wenn das mobile Element in der Endstellung im Anschlag gegen den Schalter ist, und sich schließen oder öffnen kann, wenn das mobile Element nicht in der Endstellung im Anschlag gegen den Schalter ist, wobei die Detektionsschaltung eine permanente Verbindung (6, 106) errichtet, deren Widerstandswert (7, 107) sich in Abhängigkeit von dem geschlossenen oder offenen Zustand des Schalters ändert, einem Generator (21) zur Erzeugung eines Kontrollsignals in der Detektionsschaltung, einer Signalverarbeitungseinheit (20) zum Empfang des Signals (5, 5a) am Ausgang der Detektionsschaltung zur Meldung einer Störung des Schalters, wenn die Amplitude des empfangenen Signals im Wesentlichen konstant ist und zur Meldung der offenen und geschlossenen Zustände in Abhängigkeit von dem Wert des durch die Verarbeitungseinheit empfangenen Kontrollsignals, **dadurch gekennzeichnet, dass** der Generator (21) so ausgelegt ist, dass ein Signal mit variabler Amplitude vor und während der Bewegung des mobilen Elements zu dem Schalter hin erzeugt wird, und dass die Verarbeitungseinheit so ausgelegt ist, dass der geschlossene Zustand des Schalters gemeldet wird, wenn die Amplitudendifferenz zwischen den erzeugten und empfangenen Signalen im Wesentlichen gleich einem ersten vorgegebenen Wert ist, und der offene Zustand des Schalters gemeldet wird, wenn die Amplitudendifferenz im Wesentlichen gleich einem zweiten vorgegebenen Wert ist, der größer als der erste Wert ist, und dadurch, dass die Detektionsschaltung zwischen dem Generator (21) und der Verarbeitungseinheit (20) mehrere parallel angeordnete Schalter (1, 101) aufweist, und dass die Detektionsschaltung in Reihe mit jedem Schalter (1, 101) einen zusätzlichen Widerstand (8, 108) aufweist, der wenigstens einen dritten Wert für die Amplitudendifferenz im Fall eines Kurzschlusses (23) zwischen zwei Schaltern festlegt.

7. Vorrichtung gemäß Anspruch 6, **dadurch gekennzeichnet, dass** die Detektionsschaltung einen Spannungsteiler (6, 106) aufweist, der zur Bildung einer permanenten Verbindung parallel zu jedem Schalter (1, 101) angeordnet ist, wobei der Wert des Widerstands (7, 107) des Spannungsteilers den zweiten Wert bestimmt.

8. Vorrichtung gemäß Anspruch 6 oder 7, **dadurch gekennzeichnet, dass** die Verarbeitungseinheit (20) einen Mikrocontroller und einen Analog/Digital-Wandler aufweist.

9. Vorrichtung gemäß einem der Ansprüche 6 bis 8, **dadurch gekennzeichnet, dass** die Detektionsschaltung zwischen jedem Schalter (1, 101) und der Verarbeitungseinheit (20) einen Polarisationswiderstand (9, 109) zur Masse (M) oder zu einer positiven Klemme aufweist.

10. Vorrichtung gemäß Anspruch 6, **dadurch gekennzeichnet, dass** sie in ein Kraftfahrzeug (V) eingebaut ist, um die Endschalter (13-16) wenigstens eines beweglichen Elementes wie beispielsweise eines versenkbaren Daches (T) und/oder eines Kofferraumdeckels (H) zu kontrollieren.
